# EUROPÄISCHE PATENTSCHRIFT

(11) **EP 2 531 705 B1**
(45) Veröffentlichungstag und Bekanntmachung des Hinweises auf die Patenterteilung: **25.04.2018**
(21) Anmeldenummer: 10795372.1
(22) Anmeldetag: 20.12.2010
(51) Int. Cl.: F01N 5/02, H01L 35/30

(54) **THERMOELEKTRISCHER GENERATOR MIT INTEGRIERTER VORGESPANNTER LAGERUNG**
THERMOELECTRIC GENERATOR WITH INTEGRATED PRELOADED MOUNTING
GÉNÉRATEUR THERMOÉLECTRIQUE DOTÉ D'UN PALIER PRÉCONTRAINT INTÉGRÉ

(30) Priorität: 03.02.2010 DE 102010001536
(43) Veröffentlichungstag der Anmeldung: 12.12.2012
(73) Patentinhaber: Robert Bosch GmbH, 70442 Stuttgart (DE)
(72) Erfinder: KRINN, Ilona, 70567 Moehringen (DE); KOEHNE, Martin, 71679 Asperg (DE); WETZL, Franz, 74395 Mundelsheim (DE); FELTEN, Frank, 76137 Karlsruhe (DE); SCHMITT, Manfred, 64646 Heppenheim (DE); ZIEGLER, Winfried, 75433 Maulbronn (DE); BRZOZA, Miroslaw, 71665 Vaihingen/Enz (DE); GLASER, Patrick, 70197 Stuttgart (DE)
(86) Internationale Anmeldenummer: PCT/EP2010/070183
(87) Internationale Veröffentlichungsnummer: WO 2011/095255

(56) Entgegenhaltungen:
- AT-A2- 506 262
- DE-A1-102005 036 768
- DE-A1-102007 063 196
- US-A- 5 892 656

## Beschreibung

### Stand der Technik

Zur Nutzung der Wärmeenergie von beispielsweise Verbrennungskraftmotoren ist es bekannt, thermoelektrische Generatoren zu verwenden. Beispielsweise betrifft die Druckschrift DE 10 2006 057 662 A1 ein Fahrzeug mit einem thermoelektrischen Generator, bei dem Wärmequellen und Wärmesenken in ihrem Längsverlauf senkrecht zueinander im Stapel angeordnet sind, wobei sich zwischen den einzelnen Wärmequellen und Wärmesenken thermoelektrische Elemente befinden. Wärmequelle und Wärmesenke werden von einer Vielzahl von wärmeleitenden Rohren vorgesehen, wobei die thermoelektrischen Generatorelemente zwischen die Rohre integriert sind.

Insbesondere bei der Verwendung mit Verbrennungsmotoren treten starke Temperaturschwankungen auf, die die mechanischen Verbindungen zwischen Generatorelementen und mediumführenden Rohren beeinträchtigen. Auch geringfügige Spalte verringern die Effizienz der Generatorelemente deutlich, da deren Effizienz in starker Abhängigkeit von der Temperaturdifferenz steht und auch dünne Luftspalte einen erheblichen Wärmewiderstand verursachen.

Es ist daher die Lösung bekannt, Rohre und Wärmeelemente von außen mit einer radialen Federkraft zu beaufschlagen, um die Generatoren auf die Rohre zu pressen. Die sich radial nach außen erstreckenden Federelemente, die umgänglich um die Rohre und Generatorelemente herum angeordnet sind, eignen sich grundsätzlich nicht, auch innerhalb zwischen die Rohre bzw. Generatorelemente eingefügt zu werden, da bekannte Federelemente und Anordnungen notwendigerweise einen hohen Wärmewiderstand erzeugen. Bislang bekannte thermoelektrische Generatoren mit radial wirkenden Federelementen weisen daher einen Aufbau auf, bei dem zunächst die Wärmesenke, Wärmequelle und die Generatorelemente miteinander integriert sind und ausschließlich von außen Federelemente auf die integrierte Struktur einwirken, gestützt von einer außen umlaufenden Halterung.

Eine derartige Struktur ist in US 2005/0172993 A1 dargestellt, bei der ein Abgasrohr das Zentrum bildet, um das herum thermoelektrische Elemente angeordnet sind, auf denen wiederum unmittelbar Wärmesenken angeordnet sind. Federelemente werden nur von einem äußeren, umlaufenden Band vorgesehen, das auf der Innenseite federnde Unterlegscheiben trägt, mit denen eine Außenfläche der Wärmesenken verbunden ist. Diese Art von Federung beschränkt die Wärmetauscherstruktur auf einen konzentrischen Aufbau, bei der nur eine äußere Schicht mit Federkraft beaufschlagt werden kann. Eine Übertragung einer äußeren Federkraft in das Innere des Generators bietet nicht die gewünschte mechanische Stabilität für innere Komponenten.

Die DE 10 2005 036 768 A1 offenbart ein Heizgerät mit einer thermoelektrischen Einrichtung mit mehreren Thermoelementschenkeln. US5 892 656 offenbart einen thermoelektrischen Generator mit mindestens einem Heißseitenwärmetauscher und mindestens einem Kälteseitenwärmetauscher und mindestens einem thermoelektrischen Modul mit thermoelektrischen Elementen, die in einem Spritzguss-Eiergitter eingebaut sind. Die thermoelektrischen Module werden mit dem Heißseitenwärmetauscher und dem Kälteseitenwärmetauscher mittels Federkraft in engem Kontakt gehalten.

Thermoelektrische Generatoren gemäß dem Stand der Technik sind somit in ihrem Integrationsgrad beschränkt auf einschichtige konzentrische Strukturen. Die bekannte Federstruktur ist nicht für hohe Temperaturunterschiede oder Temperaturänderungen geeignet, da zahlreiche der Generatorelemente, insbesondere die inneren Generatorelemente, bei starken Temperaturunterschieden über wärmebedingte Spalte ihre Wärmeankopplung verlieren, ohne dass dies durch Federwirkung ausgeglichen werden kann, da üblicherweise angeordnete Federelemente einen hohen Wärmewiderstand vorsehen.

### Offenbarung der Erfindung

Der erfindungsgemäße thermoelektrische Generator ermöglicht einen beliebigen Integrationsgrad, ohne dass innen liegende Generatorelemente mit einer unzureichenden Federkraft beaufschlagt werden würden. Die erfindungsgemäße Anordnung ermöglicht insbesondere eine Vorspannung der Generatorelemente und dazugehörigen Rohre (die als Sammelquelle oder Wärmesenke dienen), die von dem Ort des jeweiligen Generatorelements in dem thermoelektrischen Generator unabhängig ist. Wie oben bemerkt, erlauben erfindungsgemäße Federelementanordnungen lediglich, dass die außen liegenden Elemente mit einer Federkraft beaufschlagt werden, wobei weiter innen liegende Generatorelemente keine ausreichende Federkraft erfahren, um bei Temperaturänderungen oder auch Vibrationen den Kontakt zur Wärmesenke und zur Wärmequelle zu halten. Allerdings ermöglicht die erfindungsgemäße Struktur, dass beliebig viele Rohre und Generatorelemente zu einem kompakten Generator zusammengefasst werden können, wodurch automatisch die spezifische Oberfläche, die Integrationsdichte oder auch die Generatorleistung bezogen auf das Generatorvolumen deutlich erhöht werden kann. Gleichzeitig lässt sich die erfindungsgemäße Vorrichtung mit einfachen Mitteln vorsehen, insbesondere ohne um den eigentlichen Generator herum konzentrierte Federelemente und Stützkonstruktionen, die das Gegenlager für die gesamte Federkraft bilden. Die erfindungsgemäße Anordnung erlaubt eine platzsparende Integration der Elemente, die in einem weiten Temperaturbereich die Generatorelemente auf die jeweiligen Rohre pressen. Insbesondere wird dadurch der Umfang des Generators bei gleich bleibender Leistung (oder erhöhter Leistung) gegenüber dem Stand der Technik verringert.

Das der Erfindung zugrunde liegende Konzept ist es, die Federelemente nicht um die äußeren Rohre herum, sondern integriert in der Generatorstruktur vorzusehen. Während der Stand der Technik lediglich vorsieht, Kraft von außen auszuüben und nur die äußeren Röhren mit Federkraft zu beaufschlagen, sieht die Erfindung vor, dass eine Vorspann-Lagervorrichtung vorgesehen wird, die die Rohre selbst zueinander vorspannt und dadurch das dazwischen liegende Generatorelement mittels der Rohre zusammenpresst. Das Federkraft erzeugende Element ist hierbei zumindest zum Teil zwischen den Rohren vorgesehen, in den Rohren vorgesehen, durch die Rohre selbst vorgesehen, oder ist, beispielsweise als Teilkomponente, an der Stirnseite der Rohre vorgesehen. Das Vorspann-Lagerelement übt die Kraft unmittelbar auf die Rohre aus, entweder durch Anordnung von Federelementen in den Rohren selbst, an den Stirnseiten der Rohre (als Teilkomponente) oder durch geeignete Lagerung der Rohre, um gegebenenfalls deren Federkraft oder die Federkraft einer stirnseitigen Halterung unmittelbar auf die Rohre wirken zu lassen. Als erfindungsgemäße Federelemente werden die Rohrwände selbst verwendet, gegebenenfalls alternativ oder in Kombination mit einer stirnseitigen Halterung, die eine Bodenplatte vorsieht, oder durch Federelemente, die sich innerhalb der Rohre befinden und somit keinen zu überbrückenden Wärmewiderstand zwischen einem Generatorelement und einer Rohraußenseite vorsehen. Neben der Federkraft, die zwischen äußerem Gehäuse und den außen liegenden Generatorelementen vorgesehen wird, ermöglicht die erfindungsgemäße Anordnung, insbesondere die Vorspann-Lagervorrichtung, dass gleichermaßen nicht nur in der äußersten Schicht liegende Rohre mit einer Federkraft beaufschlagt werden. Die Vorspann-Lagervorrichtung wird erfindungsgemäß nicht ausschließlich auf der Außenseite des thermoelektrischen Generators vorgesehen, sondern auch innerhalb des Generators (d. h. innerhalb der Rohre oder an den Stirnseiten), zusammen mit Kraftverteilungselementen oder Federelementen, die durch die Rohrwände selbst vorgesehen werden, um die Federkraft unmittelbar auf innere, d.h. auf alle Komponenten zu verteilen. Gleichermaßen erzeugt die erfindungsgemäße Vorrichtung eine vorbestimmte Federkraft, die unter einer definierten Maximal-Federkraft liegt, im Wesentlichen unabhängig von dem Betriebstemperaturintervall.

Der erfindungsgemäße thermoelektrische Generator umfasst ein Gehäuse, in dem mindestens ein Wärmequellenrohr, mindestens ein Wärmesenkenrohr und mindestens ein Generatorelement angeordnet ist, wobei das Generatorelement zwischen den verschiedenartigen Rohren (d. h. zwischen einem Wärmequellenrohr und einem Wärmesenkenrohr) angeordnet ist. Die erfindungsgemäße Vorspann-Lagervorrichtung sieht eine Federkraft vor, die zwischen den Rohren wirkt, d. h. die zur Vorspannung der Rohre zueinander dient. Die Federkraft wirkt unmittelbar auf die Rohre selbst und wird nicht von außen von Rohr zu Rohr nach innen übertragen, wobei eine derartige Übertragung den Betrag der Federkraft von außen nach innen deutlich abfallen lassen würde. Erfindungsgemäß wirkt die Vorspann-Lagervorrichtung unmittelbar auf die Rohre selbst, unabhängig von deren Abstand zur Mitte des thermoelektrischen Generators. Die Vorspann-Lagervorrichtung presst so Generatorelemente durch Ausübung von Druck auf Rohre zusammen, die unmittelbar an das Generatorelement angrenzen. Die Vorspann-Lagervorrichtung ist ferner über den Querschnitt des Generators verteilt und übt unmittelbar Kraft auf die Rohre aus, indem die Vorspann-Lagervorrichtung entweder unmittelbar an den Stirnseiten der Rohre angeordnet ist oder durch die Rohrwände selbst vorgesehen wird oder durch in den Rohren vorliegende Federelemente erzeugt wird. Zwischen Vorspann-Lagervorrichtung und Rohren ergibt sich somit ein unmittelbarer mechanischer Kontakt, insbesondere durch (Teil-)Identität zwischen Vorspann-Lagervorrichtung und Rohren, durch Kraftschluss zwischen Vorspann-Lagervorrichtung und Rohren oder durch Formschluss zwischen Vorspann-Lagervorrichtung und Rohr. Dies gilt für alle Rohre des thermoelektrischen Generators, insbesondere für die innen liegenden Rohre.

Der Vorspann-Lagervorrichtung dient eine Innenseite des Gehäuses als Gegenlager. Die Innenseite des Gehäuses sieht für die Vorspann-Lagervorrichtung somit eine Stütze vor, wobei aufgrund der Ausgleichung der Federkräfte die Stütze mit einer Gegenkraft der Federkraft der Vorspann-Lagervorrichtung beaufschlagt ist. Der Betrag der Gegenkraft kann der Federkraft entsprechen, die die Vorspann-Lagervorrichtung auf die Rohre ausübt. Jedoch ist insbesondere der Gesamtbetrag der Federkraft der Vorspann-Lagervorrichtung, die auf die Rohre ausgeübt wird, größer als der Betrag der Gegenkraft, da die Rohre auch untereinander mit Spannung beaufschlagt werden, wobei dies nicht notwendigerweise zu einer gleichgroßen Gegenkraft führen muss, die auf das Gehäuse wirkt, da die Kräfte zwischen den Rohren selbst wirken und von der Lagervorrichtung somit verteilt werden. Die Vorspann-Lagervorrichtung dient zum einen zur Lagerung der Rohre und zum anderen zur Erzeugung von Vorspannung. Die Lagerung erlaubt eine Verschiebung der Rohre untereinander, um bei starken Temperaturänderungen Bewegungen auszugleichen, die von unterschiedlichen Wärmedehnungen herrühren. Die Lagerung, die von der Vorspann-Lagervorrichtung vorgesehen wird, kann ferner durch eine gefederte, d. h. vorgespannte Lagerung vorgesehen werden, wobei ein Ausgleich der auf die Rohre wirkenden Federkräfte durch Bewegung oder auch Verformung der Rohre ermöglicht wird.

Gemäß einem ersten Aspekt der Erfindung sind zur Ausführung der Vorspann-Lagervorrichtung die Rohre zwischen Bodenplatten eingespannt. Die Oberfläche der Bodenplatten weisen Mikro- oder Makrostrukturen auf, um die Stirnseiten der Rohre an ihrem Platz zu halten. Durch die Kraft, mit der die Bodenplatten auf die Stirnseiten der Rohre drücken, ergibt sich ein Kraftschluss mit einer definierten Maximal-Haftkraft, die sich aus dem Material und insbesondere aus den Mikrostrukturen ergibt, zusammen mit der Anpresskraft (d. h. Normalkraft), mit der die Rohre auf die Bodenplatten wirken. Als Mikrostruktur eignet sich insbesondere eine aufgeraute Metalloberfläche, beispielsweise durch Bürsten oder Ähnliches.

Als Makrostrukturen eignen sich beispielsweise eingeprägte oder auf andere Weise in die Oberfläche eingebrachte Profile, Erhebungen oder Vertiefungen. Spezifische Ausführungsformen für die Oberflächen werden im Weiteren näher dargestellt. Die Vorspann-Lagervorrichtung wird gebildet durch die Bodenplatten, insbesondere durch die Oberflächen der Bodenplatten, sowie durch die Stirnseiten der Rohre. Die Bodenplatten selbst können elastisch vorgesehen sein. Alternativ oder in Kombination hierzu können die Rohre selbst elastisch vorgesehen sein, so dass die Rohrwände selbst die Federwirkung vorsehen. Insbesondere dienen die Rohre dazu, die Federwirkung über die Länge der Rohre zu übertragen, so dass die Rohre mit einer geringen Elastizität ausgebildet sind.

Gemäß einer bevorzugten Ausführungsform sind die Rohre im Wesentlichen starr und üben auch bei geringen Auslenkungen eine starke Federkraft aus. Um zu vermeiden, dass die Federkraft, mit der die Generatorelemente bzw. mit der die Rohre eingespannt sind, unkontrollierbar ist und insbesondere unter einem Maximalwert bleibt, bei dem die Strukturen, insbesondere die Generatorelemente Schaden nehmen können, sieht die nicht stoffschlüssige Verbindung zwischen Rohr und Oberfläche ein Lager vor, das bei geringen Kräften zunächst die Rohre am Platz hält, jedoch bei stärkeren Kräften, die über die Maximal-Radialkraft oder Maximal-Haftkraft gehen, eine Verschiebung der Rohre vorsieht, um dadurch die Auslenkung zu verringern. Dies wird ermöglicht, indem die Bodenplatte oder die Rohre (oder beide) zumindest geringfügig elastisch vorgesehen sind, d. h. aus elastischem Material und mit einer elastischen Struktur. Anhand der Elastizität und der Abmessungen von Bodenplatte und Rohr kann abhängig von der Vorspannung der Rohre in Längskraft die Maximal-Haftkraft und die Maximal-Radialkraft genau vorgesehen werden, ab der die kraftschlüssige oder formschlüssige Verbindung zwischen Rohr und Bodenplatte nachgibt und ein Verrutschen zulässt.

Die Unterscheidung zwischen Formschluss und Kraftschluss hängt im Wesentlichen von der Betrachtung der Strukturen der Bodenplattenoberflächen ab. Auch aufeinander reibende Mikrostrukturen können als lösbarer Formschluss betrachtet werden, wenn Erhebungen der Mikrostrukturen als formschlüssige Form betrachtet werden, die aufgrund ihrer Elastizität oder Plastizität nachgeben. Die Höhe der Maximal-Haftkraft und der Maximal-Radialkraft hängt somit auch von der Höhe der Mikro- oder Makrostruktur ab, von den verwendeten Materialien und der Biegefähigkeit der Bodenplatten bzw. der Rohre. Da alle notwendigen Parameter auf einfache Weise ermittelt werden können, beispielsweise unter Verwendung einer Werkstofftabelle mit Elastizitäts- und Haftkraftangaben, ist dem Fachmann geläufig, in welcher Weise die einzelnen Komponenten auszugestalten sind, wenn eine bestimmte Maximal-Haftkraft oder Maximal-Radialkraft erzeugt werden soll. In gleicher Weise hängt die Vorspannung der Rohre in Längsrichtung von den Materialkonstanten und den Dimensionen der Komponenten ab, insbesondere von der Dicke der Bodenplatten, der Wanddicke der Rohre, der Länge der Rohre und deren Materialien.

Die Oberflächen oder Bodenplatten selbst können durch beliebige Verfahren aufgeraut sein und somit Mikrostrukturen aufweisen, durch die die Haftkraft definiert wird. Ferner können gezielt Schichten auf die Bodenplatten aufgebracht werden, um die Haftung zu erhöhen oder zu verringern. Eine bevorzugte Ausführungsform sieht jedoch vor, dass die Oberfläche der Bodenplatten oder die Bodenplatten selbst mit Makrostrukturen vorgesehen werden, die beispielsweise größer als 100 µm, größer als 200 µm oder größer als 500 µm sind, insbesondere größer als 1 mm oder 2 mm. Bei der Verwendung von Bodenplatten im Wellenprofil weisen auch deren Oberflächen Erhebungen und Vertiefungen auf, die sich wiederholen. Die Makrostrukturen können eine Rasterung aufweisen, die sich aus geraden Rillen zusammensetzt, beispielsweise Rillen, die entlang zwei verschiedener Richtungen gerade entlang der Oberfläche verlaufen. Die Makrostrukturen können ferner mit flachen Nuten dargestellt sein, beispielsweise mit einer Tiefe von 0,5 oder 1 mm. Die Erhebungen und Vertiefungen können eindimensional sein und sich nur von der Oberfläche wegerstrecken, oder können sich von der Oberfläche weg sowie entlang einer Richtung entlang der Oberfläche erstrecken. Insbesondere sind die Makrostrukturen derart ausgestattet, dass sie sich nicht mit den Stirnseiten der Rohre verkanten können. Hierzu sind die Erhebungen oder Vertiefungen im Querschnitt mit Flächen vorgesehen, die sich mit einem Winkel von deutlich weniger als 90° zu der Oberfläche erstrecken, beispielsweise mit einem Winkel von maximal 60°, 45° oder 30°. Dadurch wird ein Verkanten verhindert, auch wenn die Makrostrukturen besonders groß sind. Vorzugsweise werden Strukturen verwendet mit Oberflächen, die in mehrere Verschiebungsrichtungen nicht verkanten. Bei kleineren Makrostrukturen kann durch deren Elastizität bereits gegeben sein, dass sich diese nicht mit den Rohren verkanten können, so dass diese nicht notwendigerweise einen derartigen Querschnitt aufweisen. Ferner wird ein kontinuierlicher Verlauf der Strukturen bevorzugt, bspw. ein Wellenverlauf oder ein Dreiecksverlauf (kein Sägezahnverlauf).

Die Bodenplatte selbst ist mit dem Gehäuse stoffschlüssig verbunden oder auf andere Weise an diesem derart befestigt, dass sich die Bodenplatten im Gehäuse nicht in Längserstreckungsrichtung der Rohre bewegen können.

Weitere Ausführungsformen sehen vor, dass nur eine Art der Rohre über einen Kraftschluss oder Formschluss mit den Bodenblechen verbunden sind, wobei die andere Art der Rohre mit dem Bodenblech stoffschlüssig verbunden sein kann, beispielsweise durch eine Verschweißung. So können insbesondere die Wärmequellen mit dem Bodenblech stoffschlüssig verbunden sein, beispielsweise durch eine Schweißverbindung, und lediglich die Kühlkanäle sind verschiebbar auf der Bodenplatte angeordnet. Zudem kann eine Bodenplatte mit einer Art der Rohre verschweißt sein, und die andere Bodenplatte ist mit der anderen Art der Rohre verschweißt, wobei immer eine Rohrart auf jeder der Bodenplatten durch Formschluss bzw. Kraftschluss angeordnet ist, und die andere Rohrart durch einen Stoffschluss mit der Bodenplatte verbunden ist. Als Rohrart werden zum einen alle Wärmequellenrohre bezeichnet und zum anderen alle Wärmesenkenrohre. Wenn die Wärmesenkenrohre mit den Bodenplatten verschweißt sind und die Wärmequellenrohre per Stoffschluss oder Formschluss auf den Bodenplatten angeordnet sind, so ergeben sich auch bei starken Änderungen der Betriebstemperaturen keine strukturellen Probleme, da die Wärmequellenrohre immer einer höheren Temperatur als die Wärmesenkenrohre ausgesetzt sind und somit automatisch eine höhere Wärmeausdehnung erfahren.

Die beschriebenen Ausführungsformen können ferner mit einem gemeinsamen Sammelrohr vorgesehen sein, das an den Enden der jeweiligen Rohre angeordnet ist und die Rohre miteinander verbindet. Das Sammelrohr erstreckt sich senkrecht zur Längserstreckung der Wärmesenke- oder Wärmequellenrohre und ist vorzugsweise elastisch oder flexibel ausgestaltet. Bei der flexiblen Ausgestaltung erzeugt das Sammelrohr keine Vorspannung für die hierzu senkrecht verlaufenden Rohre, so dass die Vorspann-Lagervorrichtung im Wesentlichen die gesamten Spannungskräfte erzeugt. Alternativ kann das Sammelrohr jedoch elastisch vorgesehen sein, um zumindest einen Teil der Vorspann-Lagerrichtung vorzusehen. Derartige Ausführungsformen sind weiter unten beschrieben.

Gemäß einem zweiten Aspekt der Erfindung umfasst die Vorspann-Lagervorrichtung Federelemente, die nicht durch die Rohrwand bzw. durch das Wärmequelle- oder Wärmesenkenrohr selbst vorgesehen sind, gegebenenfalls zusammen mit den Bodenplatten, sondern die Vorspann-Lagervorrichtung wird durch einzelne Federelemente vorgesehen. Diese sind innerhalb des Wärmesenkenrohrs oder innerhalb des Wärmequellenrohrs unter Vorspannung in diesem Rohr angeordnet. Das Wärmesenkenrohr oder Wärmequellenrohr weist hierbei eine Wand auf, die elastisch ist und in der Lage ist, die Verformung, die sich durch die Vorspannung der Federelemente in den Rohren ergibt, in den Bereich (Außenbereich) zu übertragen, der das Rohr umgibt. Die Vorspannung der Federelemente wirkt auf gegenüberliegende Abschnitte von Innenseiten des Rohrs. Die Wirkungsrichtung ist radial, bezogen auf die Längsachse des Sammelquellenrohrs bzw. des Wärmesenkenrohrs, in dem sich die Federelemente befinden. Da das Rohr, in dem die Federelemente vorgesehen sind, elastisch ausgestaltet ist (durch elastische Ausstattung der Rohrwand) wird die Vorspannung an ein benachbartes Rohr weitergegeben, insbesondere über die Generatorelemente. Mit anderen Worten wird durch die flexible bzw. elastische Ausgestaltung der Rohre die Verformung durch die innen liegenden Federelemente zur Einspannung der Generatorelemente verwendet. Die Federelemente selbst weisen eine Querschnittsfläche auf, die deutlich geringer als die Querschnittsfläche des Kanals, der durch die Rohre definiert wird ist, in dem das Federelement vorgesehen ist. Das Federelement und insbesondere dessen Querschnitt ist daher ausgebildet, um innerhalb des Rohrs eine Strömung zu ermöglichen und die Strömung nur geringfügig zu beeinflussen.

In einer alternativen Ausführungsform werden ebenso individuelle Federelemente verwendet, die jedoch zwischen Endabschnitten (d.h. an Stirnseiten) mehrerer Wärmesenkenrohre angeordnet sind. Die Endabschnitte ragen über die Wärmequellenrohre hinaus. Ferner können die Federelemente zwischen Endabschnitten der Wärmequellenrohre angeordnet sein, wobei sich diese in Längsrichtung der Rohre über die Wärmesenke hinaus erstrecken. Allgemein können einige der Wärmesenke- oder Wärmequellenrohre in ihrer Länge über die anderen Rohre hinausragen, wobei zwischen den herausragenden Rohren die Federelemente vorgesehen sind und diese mit einer Vorspannung beaufschlagen, insbesondere mit einer Vorspannung, die die über die Federelemente verbundenen Rohre auseinanderdrückt. Die Federelemente üben selbst somit Kraft unmittelbar auf die Endabschnitte selbst aus, die in Längsrichtung gegenüber anderen Rohren hinausragen. Die an den Endabschnitten der Rohre angreifenden Federelemente können die Stelle der Bodenplatten einnehmen. Durch die Steifigkeit der Wärmesenkenrohre und Wärmequellenrohre verteilt sich die von den Federelementen ausgeübte Kraft entlang der Längserstreckung der Rohre. Insbesondere werden durch die Federelemente gegenüberliegende Endabschnitte der Rohre zueinander vorgespannt, die am gleichen Ende des Generators liegen.

Bei einer Ausführung, in der die Federelemente innerhalb des Wärmesenkenrohrs und innerhalb des Wärmequellenrohrs angeordnet sind, werden die Rohre elastisch oder auch flexibel ausgestaltet, indem die Wanddicke oder das Material der Rohre derart ausgewählt werden, dass eine Verformung durch die Federelemente möglich ist um Höhentoleranzen auszugleichen. Da dies von der Federkraft der Federelemente abhängt, bestimmt sich die Wanddicke oder auch das Material der Rohre durch die Federelemente. Die Wanddicke kann abhängig von dem in dem Rohr geführten Medium äußerst dünn sein, beispielsweise in Form einer Stahlfolie oder Ähnliches. Die Federelemente sind mit einer strömungsdurchlässigen Struktur vorgesehen, insbesondere durch Ausgestaltung des Profils. Die Federelemente sind beispielsweise mittels Blatt- oder Drahtfedern vorgesehen, die gegebenenfalls entlang der Längserstreckung des Rohrs ausgerichtet sind und durch die Ausrichtung eine minimale Profilfläche innerhalb des Rohrquerschnitts vorgesehen wird. Insbesondere können die Federelemente durch Metallschaum vorgesehen sein, der im Rohr vorgespannt ist. Hierzu kann der Metallschaum entweder stark gekühlt in das Rohr eingebracht werden, oder das Rohr kann zunächst erhitzt werden, bevor der Metallschaum (gegebenenfalls gekühlt) eingebracht wird. Durch die Angleichung der Temperaturen ergeben sich die Vorspannungen des Metallschaums, die sich auf die Wand des Rohrs richten. Der Metallschaum ist offenporig ausgestaltet und ermöglicht die Durchführung von Fluid. Insbesondere bei der Verwendung von Flüssigkeit als Fluid, beispielsweise Kühlwasser, ermöglicht der Metallschaum eine deutlich höhere spezifische Oberfläche, so dass der Wärmeübertrag zum flüssigen Medium stark erhöht ist. Die Verbindung des Metallschaums mit der Wand erfolgt im Stoffschluss, wodurch eine gute Wärmeleitung entsteht. Die Montage erfolgt durch Vorpressung.

In Ausführungen, bei dem die Federelemente zwischen Endabschnitten der Rohre vorgesehen sind (d. h. zwischen Endabschnitten von Rohren, die gegenüber anderen Rohren herausragen), werden die Federelemente durch Abschnitte eines in seiner Längsrichtung elastischen Rohrs vorgesehen. Ein derartiges Sammelrohr verbindet mittels seiner Abschnitte die Endabschnitte der Rohre. Dadurch werden die Wärmequellen- oder Wärmesenkenrohre miteinander über das Sammelrohr in Fluidkommunikation miteinander verbunden, die gegenüber den Wärmesenken- oder Wärmequellenrohren herausragen, die keinen mit dem Sammelrohr verbunden Endabschnitt aufweisen. Das elastische Sammelrohr, insbesondere dessen Elastizität in seiner Längsrichtung, sieht die Vorspannung zwischen den Endabschnitten vor. Das Sammelrohr verläuft im Wesentlichen senkrecht zu den Rohren, d. h. zu den Wärmesenken- und Wärmequellenrohren, und zu deren Endabschnitten.

In einer alternativen Ausführungsform ist ein ähnliches Sammelrohr vorgesehen, das jedoch flexibel ist und im Wesentlichen keine Kraft auf die Rohre ausübt, insbesondere nicht auf die Endabschnitte. Bis auf das Verformungsverhalten können die flexiblen Sammelrohre wie die elastischen Sammelrohre vorgesehen sein. Bei der Verwendung von flexiblen Sammelrohren wird jedoch eine erfindungsgemäße Vorspann-Lagervorrichtung vorgesehen, die im Wesentlichen die gesamte Vorspannung zwischen den Rohren vorsieht. Bei der oben beschriebenen Verwendung von elastischen Sammelrohren liefert das Sammelrohr selbst die Vorspann-Lagervorrichtung vor. Ein elastisches Sammelrohr dient zum einen zur beweglichen Lagerung der Wärmequellen- oder Wärmesenkenrohre und zum anderen dazu, eine Vorspannung zwischen den Rohren auszuüben. Das flexible sowie das elastische Sammelrohr sind an die Rohre angeschlossen, welche die herausragenden Endabschnitte bilden.

Der erfindungsgemäße thermoelektrische Generator kann ferner eine Strömungsführung umfassen, die an den Stirnseiten der Rohre, d. h. der Wärmesenken- und Wärmequellenrohre angeordnet ist. Diese ist zu den Rohren hin verjüngt und öffnet sich in einer Richtung von den Rohren weg, beispielsweise in Richtung einer Sammelkammer. Eine derartige Sammelkammer ist an zumindest einer der Stirnseiten der Wärmesenken- und Wärmequellenrohre angeordnet und steht in Fluidkontakt mit allen gleichartigen Rohren, d. h. mit allen Wärmequellenrohren oder mit allen Wärmesenkenrohren. Die Sammelkammer kann auch nur mit einem Teil gleichartiger Rohre in Fluidkontakt stehen. Die Strömungsführung ist zwischen der Sammelkammer und den Stirnseiten der Rohre, d. h. den Eintritten der Rohre vorgesehen. Die Strömungsführung weist für jedes Rohr eine Verjüngung auf, vorzugsweise eine bogenförmige, kontinuierliche Verjüngung oder eine Verjüngung, deren Verjüngungswinkel sich sprunghaft ändert. Bogenförmige Elemente können jedoch auch mit Abschnitten verbunden sein, deren Verjüngungswinkel sich sprunghaft ändert.

Insbesondere bei Ausführungsformen, die Bodenplatten umfassen, weisen diese Öffnungen an den Eintritten der Rohre, d. h. an den Stirnseiten der Rohre auf, um einen Fluidfluss zu ermöglichen. Die Öffnungen einer Bodenplatte sind nur einer Art von Rohren, d. h. den Wärmesenkenrohren oder den Wärmequellenrohren zugeordnet, wobei die Bodenplatte keine Öffnung oder Verbindung für die andere Art von Rohren vorsieht. Bei der Verwendung von zwei Bodenplatten sind diese unterschiedlichen Rohrarten zugeordnet. An die Bodenbleche schließt sich, auf der von den Rohren abgewandten Seite, eine Sammelkammer an, über die die Rohre mit dem geeigneten Medium beaufschlagt werden.

Bei der Verwendung von Sammelrohren verbinden diese an einer Seite der Rohre nur eine bestimmte Rohrart, nämlich diejenige Rohrart, deren Endabschnitte über die anderen Rohre hinausragt. Die andere Art von Rohren, d. h. die zurückversetzten Rohre, sind in Fluidkommunikation mit einer Sammelkammer, die sich an der gleichen Seite wie das Sammelrohr an die Rohre anfügt. Über die Sammelkammer werden die zurückversetzten Rohre mit einem Medium bestückt, das sich von dem Medium unterscheidet, welches sich in dem Sammelrohr befindet. Da das Medium in dem Sammelrohr grundsätzlich eine andere Temperatur aufweist wie das Medium in der Sammelkammer, wird vorzugsweise eine Wärmeisolation vorgesehen, die das Sammelrohr gegenüber der Sammelkammer hinsichtlich Wärmeübertragung trennt. Ansonsten kann sich das Sammelrohr zum Teil durch die Sammelkammer hindurch erstrecken, wobei diese jedoch fluidtechnisch getrennt sind und auch vorzugsweise zueinander wärmeisoliert sind.

Die Erfindung wird ferner umgesetzt durch ein Verfahren zur Herstellung des erfindungsgemäßen thermoelektrischen Generators. In einem Gehäuse wird mindestens ein Wärmequellenrohr, mindestens ein Wärmesenkenrohr und mindestens ein Generatorelement eingebracht, wobei das Generatorelement zwischen dem Wärmequellenrohr und dem Wärmesenkenrohr angeordnet ist. In dem Gehäuse wird ferner eine Vorspann-Lagervorrichtung angeordnet, die eine Federkraft zur Ausübung der Vorspannung erzeugt, mit der die Rohre zueinander vorgespannt werden und die Rohre dadurch das dazwischen liegende Generatorelement zusammenpressen. Entweder werden hierbei die Rohre in die Vorspann-Lagervorrichtung eingespannt, wenn die Vorspann-Lagervorrichtung, gemäß dem ersten Aspekt der Erfindung Bodenplatten umfasst, oder die Vorspann-Lagervorrichtung wird in die Rohre eingebracht, d. h. unter Vorspannung in die Rohre eingespannt. Dies ist gemäß dem zweiten Aspekt der Erfindung der Fall, wenn die Vorspann-Lagervorrichtung durch einzelne, in den Rohren befindliche Federelemente vorgesehen wird, beispielsweise durch Einfügen von Blattfederelementen, Drahtfederelementen oder Metallschaum unter Vorspannung. Neben der Vorspannung zwischen den Rohren wird verfahrensgemäß auch eine Vorspannung zwischen den Rohren und den Innenseiten des Gehäuses durch Beaufschlagung der Innenseite des Gehäuses mit einer Kraft vorgesehen, wodurch die Vorspann-Lagervorrichtung von dem Gehäuse abgestützt wird.

Die Rohre, d. h. die Wärmequellenrohre, die Wärmesenkenrohre und die Sammelrohre, sowie das Gehäuse und die Bodenbleche werden aus Metall vorgesehen, vorzugsweise aus Stahl, Aluminium oder Kupfer. Bei der Verwendung von Blatt- oder Drahtfedern werden diese vorzugsweise aus Federstahl vorgesehen, insbesondere mit einer witterungsbeständigen Beschichtung, um die Federelemente vor dem entsprechenden Wärmemedium zu schützen. Bei der Verwendung von Metallschaum wird dieser vorzugsweise aus Aluminium ausgestaltet oder aus anderen Metallen oder Legierungen. Bei der Verwendung von Metallschaum als vorgespannte Federelemente wird die Vorspannungskraft eingestellt durch geeignete Auswahl der Porengröße sowie durch die Stärke der Verformung, die zu der Vorspannung führt.

Das Gehäuse selbst kann ferner Flansche aufweisen, die zu beiden Seiten des Generators angeordnet sind. Zwischen dem Flansch und den Stirnseiten der Rohre ist die Sammelkammer innerhalb des Gehäuses ausgebildet. Darüber hinaus können Anschlüsse vorgesehen sein, die über flexible Verbindungsrohre mit dem jeweiligen Wärmesenken- oder Wärmequellenrohr verbunden sind. Insbesondere wird der Flansch zur Zuführung von gasförmigen Medien, insbesondere von heißem Verbrennungsgas verwendet. Dadurch ergibt sich ein geringer Rückstau für einen daran anzuschließenden Verbrennungsmotor. Der Generator umfasst ferner vorzugsweise zu beiden Seiten ein flexibles oder auch elastisches Sammelrohr, welches die Wärmesenkenrohre zu beiden Seiten des Generators jeweils miteinander verbindet, um dem Generator Kühlflüssigkeit zuzuführen und aus diesem abzuführen.

Als Generatorelement eignen sich insbesondere Seebeck- oder Peltier-Elemente. Die Generatorelemente umfassen vorzugsweise dotiertes Halbleitermaterial, insbesondere zumindest einen Körper, der n-dotiert ist, und zumindest einen weiteren Körper, der p-dotiert ist. Ferner umfassen die Generatorelemente einen elektrisch leitenden Verbindungskontakt, der die unterschiedlich dotierten Halbleiterelemente miteinander verbindet, sowie eine Anschlusskontaktierung für Pluspol oder Minuspol.

### Kurze Beschreibung der Zeichnungen

- Die Figur 1: zeigt eine erste Ausführungsform eines erfindungsgemäßen thermischen Generators im Längsschnitt.
- Die Figur 2: zeigt einen Teilaspekt einer zweiten Ausführungsform eines thermischen Generators.
- Die Figur 3: zeigt eine Prinzipdarstellung einer dritten Ausführungsform eines thermoelektrischen Generators.
- Die Figur 4: zeigt eine vierte Ausführungsform eines erfindungsgemäßen thermoelektrischen Generators im Längsschnitt.

### Detaillierte Beschreibung der Zeichnungen

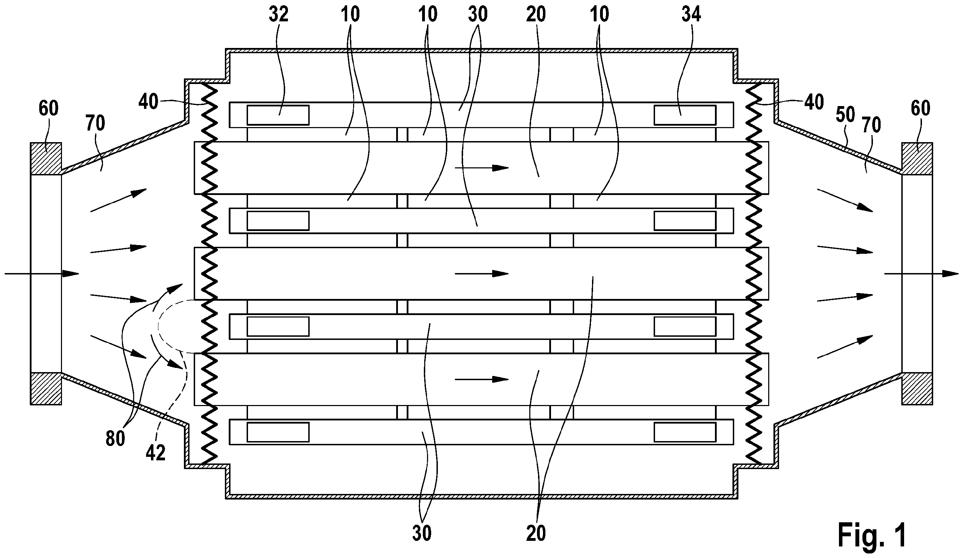

Die in Figur 1 dargestellte erste Ausführungsform eines thermoelektrischen Generators umfasst Generatorelemente 10, die um ein Wärmequellenrohr 20 von mehreren Wärmequellenrohren 20 angeordnet sind. Auf den Seiten der Generatorelemente 10, die von dem Wärmequellenrohr 20 abgewandt sind, befindet sich ein Wärmesenkenrohr 30 in Form eines Kühlkanals für Kühlflüssigkeiten. Jedes Generatorelement ist somit beidseitig zwischen ein Wärmequellenrohr in Form eines Abgaskanals 20 und an ein Wärmesenkenrohr in Form eines Kühlkanals 30 angeschlossen. Die Rohre 20, 30 sowie die Generatorelemente 10 sind in einem Gehäuse 50 angeordnet, das entlang seines Umfangs geschlossen ist und zwei offene Enden aufweist, um Wärmequellenmedium in den Generator einzuführen und von diesem abzuleiten. Die Öffnungen sind in Form eines Flanschs 60. Die Wärmesenkenrohre weisen an jeweils beiden Enden einen Anschluss 32, 34 auf, wobei die Anschlüsse 32 aller Wärmesenkenrohre einer Seite des Generators miteinander verbunden sind und alle Anschlüsse 34 der entgegengesetzten Enden der Wärmesenkenrohre miteinander verbunden sind. Die Sammelleitungen beider Enden weisen jeweils einen nach außen führenden Anschluss auf, der in Figur 1 aus Gründen der Übersicht nicht dargestellt ist. Diese Anschlüsse werden jeweils durch das Gehäuse hindurch nach außen geführt.

Die Wärmesenkenrohre werden zu beiden Seiten von jeweils einem Bodenblech 40 gehalten, wobei das Bodenblech 40 die Wärmesenkenrohre 30 im Presssitz hält. Wie symbolisch dargestellt, sind die Bodenbleche gewellt. Durch die Wellenform der Bodenbleche 40 sowie durch deren Dicke sind diese elastisch und bieten eine Vorspannkraft für die dazwischen liegenden Wärmequellenrohre 20. Die Bodenbleche 40 weisen somit jeweils eine Oberfläche auf, die der Stirnseite der Wärmequellenrohre 20 zugewandt ist, um diese zusammenzupressen. Aufgrund der Wellenform ist es ferner möglich, dass die Wärmequellenrohre insbesondere bei stärkerer Wärmeausdehnung zueinander und insbesondere gegenüber dem anstoßenden Bodenblech 40 verrutschen können, wobei die Versatzdistanz des Verrutschens definiert ist durch die Wellenform. Somit besteht zu jedem Zeitpunkt ein fester Halt, wobei bei Überschreitung einer Maximal-Radialkraft die Stirnseiten der Rohre in ein benachbartes (oder im Allgemeinen anderes) Wellental verrutschen können. In der Höhe der Wärmequellenrohre bzw. an deren Stirnseiten bzw. stirnseitigen Öffnungen sind Öffnungen in dem Bodenblech 40 vorgesehen, die eine Fluidkommunikation zwischen den Wärmequellenrohren und dem Raum des Gehäuses vorsehen, der sich in Fortsetzung an die Längserstreckung der Rohre innerhalb des Gehäuses anschließt. Das Gehäuse bildet somit Kammern 70 der Wärmequellenrohre bzw. Wärmesenkenrohre. Die Öffnungen in den Bodenplatten 40 sind dergestalt, dass zwar beispielsweise Abgas im Wesentlichen ungehindert durch das Bodenblech hindurch in die Wärmequellenrohre 20 eintreten kann, verhindern jedoch gleichzeitig durch ihre Struktur, dass die Wärmequellenrohre durch das Bodenblech hindurchtreten. In ihrer Längserstreckung sind die Stirnseiten der Wärmequellenrohre 20 zu den Stirnseiten der Wärmesenkenrohre 30 versetzt, wobei die Wärmequellenrohre über die Wärmesenkenrohre zu beiden Seiten hinausstehen. Dies ermöglicht eine Kontaktierung des Bodenblechs ausschließlich mit den Wärmequellenrohren. Das Bodenblech ist fest mit dem Gehäuse 50 verbunden, beispielsweise durch eine Schweißnaht oder eine stoffliche Verbindung. Die Stirnseiten der Wärmequellenrohre 20 können jedoch eine Relativbewegung zu den Bodenblechen, insbesondere relativ zu dem Gehäuse 50 ausführen. An dem Bodenblech können ferner optional bogenförmige Elemente 42, beispielsweise in Form eines Halbkreises oder eines Paraboloids, der sich zwischen zwei zugewandten Seiten der Wärmequellenrohre erstreckt, angebracht sein. Die Bogenelemente 42 können auf dem Bodenblech aufgeschweißt sein oder können einteilig und durchgängig mit dem Bodenblech ausgeführt sein, wobei das Bodenblech an den Stellen der Bogenelemente sich nicht entlang einer Ebene erstreckt. An den Kontaktstellen der Stirnseiten der Wärmequellenrohre 20 zu dem Bodenblech ist das Bodenblech jedoch in seiner Gesamtform eben ausgeführt (jedoch mit einer Wellenform als Makrostruktur vorgesehen). Die Bogenelemente decken in ihrer Quererstreckung den Abstand ab, der sich zwischen benachbarten Wärmequellenrohren 20 ergibt und decken somit in Projektion in Längsrichtung des Generators die Wärmesenkenrohre 30 und die Generatorelemente 10 ab. Die mit durchgezogenen Linien dargestellten Pfeile stellen die Strömung des Abgases dar, das zu einer Seite des thermoelektrischen Generators in den jeweiligen Flansch eintritt, durch die Wärmequellenrohre 20 geführt wird und auf der entgegengesetzten Seite austritt. An den Pfeilen 80 ist erkennbar, dass das optionale Bogenelement 42, gestrichelt dargestellt, den Gasstrom im Wesentlichen turbulenzfrei aufteilt auf benachbarte Wärmequellenrohre 20.

Die Strömungsrichtung der Wärmesenkenrohre 30 ist durch die Belegung der Anschlüsse 32, 34 definiert und kann parallel oder antiparallel zu der Strömungsrichtung des Mediums sein, das durch die Wärmequellenrohre 20 fließt.

In der in Figur 1 dargestellten Ausführung wird die Vorspann-Lagervorrichtung durch die Bodenbleche 40 in Wellenform sowie durch die Stirnseiten der Wärmequellenrohre 20 gebildet, wobei durch die Bodenbleche zum einen die Wärmequellenrohre eine stauchende Kraft erfahren und die Wellenform, gegebenenfalls zusammen mit wärmebedingten Längenänderungen, eine Radialkraft senkrecht zur Längsachse des Generators erfährt.

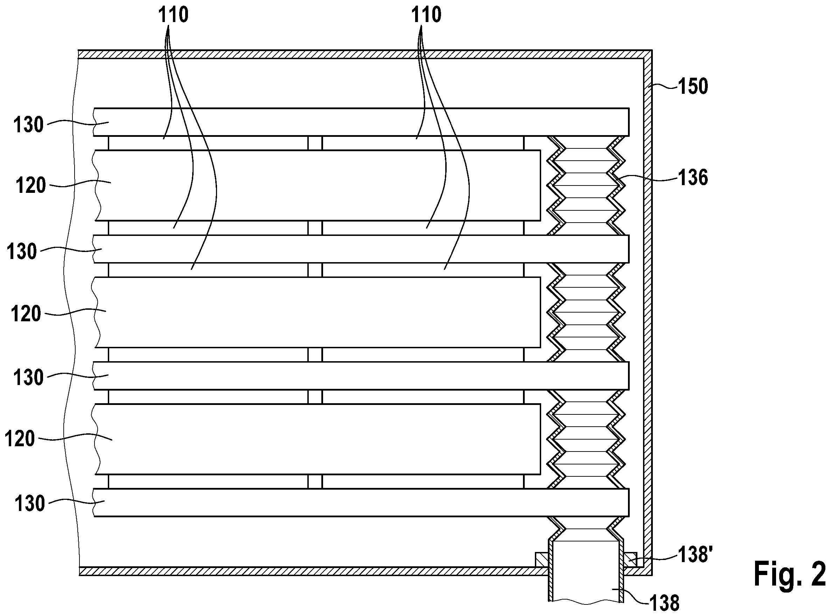

Die Figur 2 zeigt eine zweite Ausführungsform der Erfindung, die mit der anhand von Figur 1 dargestellten Ausführungsform kombinierbar ist. Der in Figur 2 dargestellte Generator umfasst Generatorelemente 110, die zwischen Wärmequellenrohren 120 und Wärmesenkenrohren 130 ausgebildet sind. Die Figur 2 ist eine Vorderansicht, d. h. ein Querschnitt der Längsdarstellung von Figur 1. Zunächst ist zu erkennen, dass die Wärmequellenrohre und die Wärmesenkenrohre einen flachen quadratischen Querschnitt aufweisen, so dass der dadurch gebildete Kanal gegenüber seiner Querschnittsfläche einen großen Umfang aufweist. Dadurch ergibt sich ein hohes spezifisches Volumen. Die Wärmesenkenrohre 130 sind über eine flexible Verbindungsleitung bzw. deren Abschnitte 136 miteinander verbunden. Die Verbindungsleitung verbindet die in Figur 1 dargestellten Anschlüsse 32 bzw. 34 der Wärmesenkenrohre, d. h. der Kühlkanäle. Die Verbindungsleitung dient als Sammelrohr bzw. als Sammelleitung für die Kühlflüssigkeit, und weist einen durch das Gehäuse 150 hindurchragenden Anschluss 138 auf, der mittels Dichtungen 138' mit dem Gehäuse abgedichtet ist. Die in Figur 2 dargestellte Ausführungsform sieht vor, dass die Sammelleitung bzw. das Sammelleitungsrohr 136 flexibel ist und somit im Wesentlichen keine Kraft auf die Wärmesenkenrohre 130 ausübt. Gemäß einer nicht dargestellten Ausführungsform ist das Sammelrohr 136 aus elastischem Material vorgesehen, um so eine seitliche Vorspannung für die Wärmesenkenrohre 130 vorzusehen. Durch die Vorspannung werden benachbarte Wärmesenkenrohre 130 zueinander gezogen, so dass sich durch das Sammelrohr 136 eine Vorspann-Lagervorrichtung ergibt. Neben der Ausübung einer Vorspannungskraft dient ein elastisches Sammelrohr auch der Lagerung, zusammen mit den zwischen den Wärmesenkenrohren 130 vorgesehenen Elementen (d. h. Wärmequellenrohre 120 und Generatorelemente 110).

Das Sammelrohr 136 (sei es elastisch oder flexibel) erstreckt sich entlang einer Kante des Bündels, das durch die Wärmequellenrohre und Wärmesenkenrohre sowie durch die Generatorelemente gebildet wird. Das Sammelrohr 136 erstreckt sich senkrecht zu der Längsebene des Bündels und an einer Höhenkante des Bündels. Das Sammelrohr 136 kann sich jedoch auch seitlich von dem Bündel erstrecken, d. h. senkrecht zur Erstreckungsebene des Bündels und an einer Seitenfläche des Bündels, die sich entlang der Erstreckungsrichtung der Rohre erstreckt. Anhand der Figuren 1 und 2 ist zu erkennen, dass in Längsrichtung die Wärmesenkenrohre 30; 130 gegenüber den Wärmequellenrohren 20; 120 verkürzt sind, jedoch in Querrichtung hierzu sich über diese hinaus erstrecken, um eine Anordnung der Sammelleitung 136 zu ermöglichen.

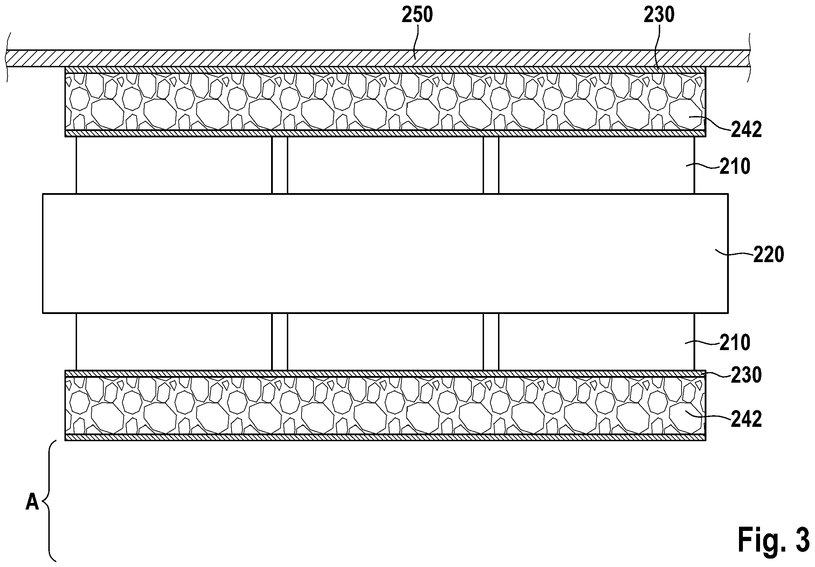

Die Figur 3 zeigt einen Querschnitt einer alternativen Ausführungsform der Erfindung in Symboldarstellung. Der in Figur 3 dargestellte Generator umfasst Generatorelemente 210, die zwischen einem Wärmequellenrohr 220 und Wärmesenkenrohren 230 angeordnet sind. Eine Gehäusewand 250 stützt hier beispielhaft ein Wärmesenkenrohr 230 ab, während ein gegenüberliegendes Wärmesenkenrohr 230 von darauf folgenden Generatorelementen (und weiteren Wärmequellenrohren) im Abschnitt A abgestützt wird. Mit der Abstützung ist eine Vorspannung verbunden, die die beiden Wärmesenkenrohre 230 und diese Zwischenlinienkomponenten 210, 220 zusammenpresst. In den Wärmesenkenrohren 230 ist Metallschaum 242 vorgesehen, der gegen die Innenwände der jeweiligen Rohre 230 drückt. Die Rohre 230 sind dünnwandig, bzw. elastisch oder plastisch, so dass der Druck in Form von Verformung nach außen weitergeben werden kann. Somit überträgt die Rohrwand der Wärmesenkenrohre 230 die Federkraft, die der Metallschaum 242 ausübt. Gleichzeitig ist der Metallschaum 242 porös bzw. hat er eine strömungsdurchlässige Struktur, so dass Kühlmittel durch den Kühlkanal 230 hindurch geleitet werden kann. Aufgrund der Porosität des Metallschaums ergibt sich ein deutlich verbesserter Wärmeübertrag, da die spezifische Oberfläche des Metallschaums im Vergleich zu der Innenfläche eines Rohrs deutlich höher ist. Weiterhin ergibt sich durch den Metallschaum eine homogene Kraftbeaufschlagung der Rohrinnenwand. Aufgrund der Elastizität und weiterer mechanischer Eigenschaften wirkt der Metallschaum vibrationsdämpfend, insbesondere dadurch, dass Flüssigkeit innerhalb des Metallschaums vorgesehen ist und somit Vibrationen durch (kleinere) Turbulenzen oder durch externe Vibrationen des Abgasrohrsuptoms abgedämpft werden.

Es sind ferner keine Rippen zur Versteifung des Rohrs 230 vorgesehen, so dass das Rohr mit einem rechteckigen Querschnitt mit hohem Seitenverhältnis hergestellt werden kann, d. h. mit einer Breite, die ein Vielfaches der Dicke ist. Ferner ist die Steifigkeit gegenüber Kanälen mit Versteifungsrippen homogen in Längsrichtung sowie in Querrichtung des Kanals. Die dämpfenden Eigenschaften des Metallschaums führen unmittelbar zu einer Erhöhung der Lebensdauer des Systems und verhindern, dass Vibrationen Wärmelücken entstehen lassen.

Die in Figur 3 dargestellte Ausführungsform eignet sich insbesondere für langsam strömende Kühlfluide, wobei die geringe Geschwindigkeit der Strömung durch die substanziell erhöhte spezifische Oberfläche des Metallschaums mehr als kompensiert wird. Darüber hinaus kann durch die geringe Wanddicke des Kanals bzw. des Rohrs Material eingespart werden, wodurch sich zusätzlich eine Gewichtsverringerung ergibt. Aufgrund der homogenen Verteilung der Vorspannung durch den Metallschaum müssen keine kraftverteilenden Elemente eingesetzt werden. Grundsätzlich kann der Metallschaum im Wärmequellenrohr oder im Wärmesenkenrohr eingesetzt werden. Bevorzugt wird jedoch der Metallschaum in dem Wärmesenkenrohr angeordnet, da die niedrigen Temperaturen es ermöglichen, dass Schäume aus verschiedenen Materialien eingesetzt werden. Neben Metallschäumen können beispielsweise auch Kunststoffschäume eingesetzt werden oder andere Materialien, soweit diese eine Struktur aufweisen, die eine Strömung in Längsrichtung ermöglicht. Ferner kann prinzipiell anstatt des Metallschaums auch ein unter Radialspannung stehendes Innenrohr in das Wärmesenkenrohr eingebracht werden, das eine nach außen wirkende Radialkraft erzeugt. Eine derartige Radialkraft kann ferner prinzipiell auch durch einen Druckunterschied erzeugt werden, der zwischen dem Inneren des Wärmesenkenrohrs und der Umgebung des Wärmesenkenrohrs besteht. Soweit das Wärmesenken- oder Wärmequellenrohr flexibel oder elastisch ist, lässt sich durch einen Überdruck die gewünschte Vorspannung erreichen, soweit die Rohre von außen durch eine Gehäuseinnenwand eine Gegenkraft erfahren.

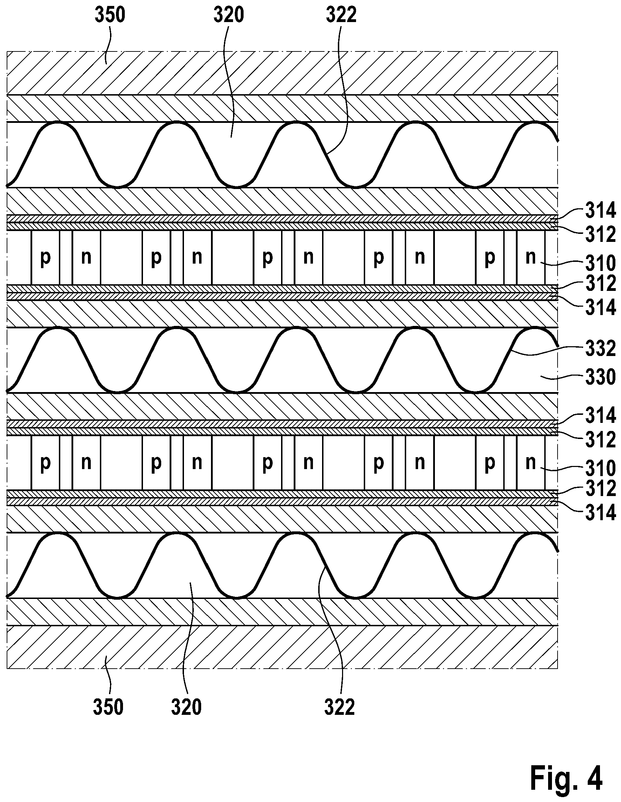

In der Figur 4 ist eine vierte Ausführungsform des erfindungsgemäßen thermoelektrischen Generators im Querschnitt dargestellt, der ein Gehäuse 350 umfasst, in dem thermoelektrische Elemente 310, Wärmequellenrohre 320 sowie ein Wärmesenkenrohr 330 vorgesehen sind. Die Generatorelemente 310 umfassen paarig angeordnete Halbleiterschenkel, die abwechselnd unterschiedlich dotiert sind (p- bzw. n-dotiert sind). Die Generatorelemente 310 umfassen ferner Leiterbahnen (nicht dargestellt), die sich an deren Stirnseiten befinden. Die Generatorelemente sind über eine Wärmeleitpastenschicht 312 mit einer elektrischen Isolierschicht, beispielsweise aus Keramik 314 mit den äußeren Rohrwänden des Wärmequellenrohrs 320 zu einer Seite und zu der anderen Seite mit dem Wärmesenkenrohr 330 verbunden. Es ergibt sich somit für die Generatorelemente eine Temperaturdifferenz, aus der diese elektrische Leistung erzeugen.

Innerhalb der Wärmequellenrohre 320 und des Wärmesenkenrohrs 330 sind Federelemente 322 bzw. 332 vorgesehen, die unmittelbar Druck auf die Innenwände des jeweiligen Rohrs ausüben. Das untere Wärmequellenrohr 320 wird gebildet aus einer Rohrwand sowie, gegenüberliegend, durch die Innenfläche des Gehäuses 350. Das untere Wärmequellenrohr 320 ist somit vorgesehen von einer inneren Hülle, die das Wärmequellenmedium von den Generatorelementen isoliert, sowie das umlaufende Gehäuse 350. Dadurch lassen sich Material und Platz einsparen; durch die Doppelverwendung einer Hülle zwischen dem Wärmequellenmedium bzw. dem Wärmesenkenmedium lässt sich zumindest für die äußeren Rohre 320 (oder auch 330) eine Rohrwand einsparen. Hierbei weist auch, im Gegensatz zu dem oberen Wärmequellenrohr 320, die Innenwand des Gehäuses 350 eine Doppelfunktion auf, indem zum einen das Gehäuse eine stabile Umrandung als Gegenlager für die Federkräfte vorsieht und zum anderen die Fluid leitenden Eigenschaften eines Wärmequellen- bzw. Wärmesenkenrohrs.

Die Federelemente 322 treffen auf die Innenseiten der Rohre (bzw. im Falle des unteren Wärmequellenrohrs auf die Gehäuseinnenseite) und üben somit einen zu den benachbarten Generatorelementen sowie zu den weiteren Rohren gerichteten Druck aus. Um dies zu ermöglichen, sind die Wände der verwendeten Rohre 320, 330 elastisch bzw. flexibel, um so eine Verformung durch die Federelemente 332 an außen liegende Komponenten weitergeben zu können. Die Federelemente 332 sind in Figur 4 lediglich symbolhaft dargestellt; insbesondere können Blattfedern, Spiralfedern oder Drahtfedern verwendet werden, die sich vorzugsweise entlang des gesamten Rohrs erstrecken. Gegebenenfalls können ferner Federelemente vorgesehen sein, die nur in Längsabschnitten der Rohre angeordnet sind, bzw. auf diese wirken, wobei in diesem Fall ein Kraftverteilungselement vorgesehen ist, um die Federkraft im Wesentlichen homogen auf die Wandinnenseiten der Rohre 320, 330 zu verteilen. Derartige Federkraftübertragungselemente bzw. Elemente zur Homogenisierung der Kraftbeaufschlagung können aus zwei Hälften eines Zylindermantels gebildet werden, zwischen denen die Federelemente angeordnet sind. Abhängig von der Ausgestaltung der Rohrwand übernimmt jedoch diese die Aufgabe der Homogenisierung der Kraftbeaufschlagung.

Die Darstellung der Figur 4 ist, wie auch die Darstellungen der Figuren 1-3 symbolhaft und nicht maßstäblich, insbesondere im Hinblick auf die Dicke der Rohrwände, wenn diese als flexible als elastische Strukturen ausgeführt sind. Im Allgemeinen bilden die Wärmequellenrohre und die Wärmesenkenrohre einen Kanal mit einem rechteckigen Querschnitt, insbesondere mit einem Querschnitt, der ein hohes Seitenverhältnis aufweist. Durch das hohe Seitenverhältnis (= Breite zu Höhe) wird ermöglicht, dass die Rohre eine hohe Außenfläche bzw. Innenfläche im Vergleich zu geringem Volumen vorsehen. Die Rohre verlaufen vorzugsweise parallel zueinander und können in ihrer Höhe sowie in ihrer Breite nebeneinander aufgereiht sein. Die Generatorelemente sind insbesondere in eine Richtung zwischen die Rohre gestapelt, die senkrecht zur Erstreckungsrichtung des Generators ist. Jedoch können auch Generatorelemente in Quererstreckung des Generators zwischen den Rohren vorgesehen sein. Vorzugsweise sind die Generatorelemente auf die Außenflächen der Wärmequellen- oder Wärmesenkenrohre über ein Wärme übertragendes Element angekoppelt, beispielsweise mittels einer thermisch gut leitende Schicht. Vorzugsweise ist diese Schicht elektrisch isolierend ausgeführt, so dass sich beispielsweise Materialien wie Keramik, Al₂O₃, AIN, Steatit, Fosterit, Emaille oder Ähnliches anbieten. Falls die thermisch gut leitenden Schicht nicht vollständig elektrisch isoliert ist, so wird ein weiteres elektrisch isolierendes Element verwendet, vorzugsweise mit einer geringen Dicke, um zusätzlich eine elektrische Isolation vorzusehen. Wie in Figur 4 dargestellt, sind die einzelnen Generatorelemente bzw. deren thermoelektrisch aktive Körper über eine Kontaktschicht (beispielsweise eine Leiterbahn) nur über ein wärmeverbindendes Element, beispielsweise eine elektrisch isolierende und thermisch leitende Schicht an die Außenwände der Rohre thermisch angebunden.

In der Figur 4 ist dargestellt, dass alle Rohre, d. h. alle Wärmequellen- und Wärmesenkenrohre, in sich Federelemente 322, 332 tragen. Jedoch kann dies nur einige der Rohre betreffen, beispielsweise nur die Wärmesenken- oder nur die Wärmequellenrohre, wobei jedoch nicht notwendigerweise alle gleichartigen Rohre ein Federelement tragen müssen. Das Federelement ist insbesondere nicht nur in einem Rohr vorgesehen, das unmittelbar an das Gehäuse angrenzt, sondern ist auch in einem Wärmesenken- oder Wärmequellenrohr vorgesehen, das sich innerhalb des Generators befindet und nicht unmittelbar an das Gehäuse angrenzt. Dadurch ergibt sich eine Verspannung, die ihre Ursache nicht nur im Außenrand des Generators hat, insbesondere in einem Rand, der unmittelbar an das Gehäuse anschließt, sondern auch von innerhalb des Stapels wirkt. Dadurch ergibt sich eine robustere, vibrationsfeste und homogenere Verpressung der Rohre mit den Generatorelementen.

## Patentansprüche

1. Thermoelektrischer Generator mit einem Gehäuse (50), in dem mindestens ein Wärmequellenrohr (20), mindestens ein Wärmesenkenrohr (30) und mindestens ein Generatorelement (10) zwischen dem Wärmequellenrohr und dem Wärmesenkenrohr angeordnet sind, wobei in dem Gehäuse eine Vorspann-Lagervorrichtung (40; 136; 242; 322, 332) vorgesehen ist, die eine Federkraft vorsieht, mit der zumindest ein Teil der Rohre (20, 30) unmittelbar beaufschlagt wird und mit der die Rohre zueinander vorgespannt werden, und die die Rohre (20, 30) sowie das dazwischen liegende Generatorelement (10) zusammenpresst, wobei eine Innenseite des Gehäuses (50) eine Stütze für die Vorspann-Lagervorrichtung vorsieht, die mit einer Gegenkraft der Federkraft der Vorspann-Lagervorrichtung beaufschlagt ist, **dadurch gekennzeichnet, dass** die Vorspann-Lagervorrichtung zwei Bodenplatten (40) umfasst, die mit dem Gehäuse fest verbunden sind, wobei die Rohre (20, 30) der Länge nach zwischen Oberflächen der Bodenplatten eingespannt sind, die den Rohren zugewandt sind und Mikro- oder Makrostrukturen aufweisen, die mit Stirnseiten der Rohre einen Kraftschluss mit einer definierten Maximal-Haftkraft oder einen durch eine definierte Maximal-Radialkraft lösbaren Formschluss bilden, und wobei die Vorspann-Lagervorrichtung durch die Bodenplatten, deren Oberflächen und die Stirnseiten der Rohre (20, 30) gebildet werden.

2. Thermoelektrischer Generator nach Anspruch 1, wobei die Bodenplatten (40), die Rohre (20, 30) oder beides aus zumindest geringfügig elastischem Material ausgebildet sind, wobei die Maximal-Haftkraft und die Maximal-Radialkraft definiert ist durch die Elastizität des elastischen Materials und durch die Höhe der Mikro- oder Makrostruktur; die Vorspann-Lagervorrichtung die Rohre mit zwei Freiheitsgraden in Richtungen lagert, die entlang der Oberflächen verlaufen, und entlang denen die Vorspann-Lagervorrichtung auch eine Vorspannung verläuft, mit der die Rohre beaufschlagt werden und die von der Elastizität der Bodenplatten bzw. der Rohre erzeugt wird.

3. Thermoelektrischer Generator nach Anspruch 1 oder 2, wobei die Oberflächen oder die Bodenplatten (40) selbst als Makrostrukturen ein Wellenprofil oder eine Rasterung aufweisen, das in mindestens zwei Richtungen entlang der Oberfläche sich wiederholende Erhebungen oder Vertiefungen aufweist.

4. Thermoelektrischer Generator mit einem Gehäuse (50), in dem mindestens ein Wärmequellenrohr (20), mindestens ein Wärmesenkenrohr (30) und mindestens ein Generatorelement (10) zwischen dem Wärmequellenrohr und dem Wärmesenkenrohr angeordnet sind, wobei in dem Gehäuse eine Vorspann-Lagervorrichtung (40; 136; 242; 322, 332) vorgesehen ist, die eine Federkraft vorsieht, mit der zumindest ein Teil der Rohre (20, 30) unmittelbar beaufschlagt wird und mit der die Rohre zueinander vorgespannt werden, und die die Rohre (20, 30) sowie das dazwischen liegende Generatorelement (10) zusammenpresst, wobei eine Innenseite des Gehäuses (50) eine Stütze für die Vorspann-Lagervorrichtung vorsieht, die mit einer Gegenkraft der Federkraft der Vorspann-Lagervorrichtung beaufschlagt ist, **dadurch gekennzeichnet, dass** die Vorspann-Lagervorrichtung Federelemente (242; 322, 332) umfasst, die innerhalb des Wärmesenkenrohrs oder innerhalb des Wärmequellenrohrs unter Vorspannung in dem Rohr angeordnet sind, wobei die Vorspannung der Federelemente (242; 322, 332) auf gegenüberliegende Abschnitte von Innenseiten des Rohrs (220, 230; 320, 330) radial nach außerhalb der Innenseiten wirkt und das Rohr, in dem die Federelemente vorgesehen sind, elastisch ausgestaltet ist, um die Vorspannung an ein benachbartes Rohr weiterzugeben, oder wobei die Federelemente (136) zwischen Endabschnitten mehrer Wärmesenkenrohre oder Wärmequellenrohre angeordnet sind, die in Längserstreckung oder Quererstreckung der Rohre über die Wärmequellenrohre bzw. Wärmesenkenrohre hinausragen, wobei die Vorspannung der Federelemente auf gegenüberliegende Endabschnitte drückt.

5. Thermoelektrischer Generator nach Anspruch 4, wobei die Federelemente (242; 322, 332) innerhalb des Wärmesenkenrohrs oder des Wärmequellenrohrs angeordnet sind und die elastische Ausgestaltung der Rohre, in denen die Federelemente angeordnet sind, vorgesehen wird durch eine Ausgestaltung der Wanddicke und des Materials der Rohre, die diese in die Lage versetzt, in ihrem Querschnitt durch die Federelemente verändert zu werden, wobei die Federelemente eine Struktur aufweisen, die strömungsdurchlässig ist, die Federelemente durch in dem Rohr vorgespannte Blatt- oder Drahtfedern (322, 332) vorgesehen werden oder die Federelemente durch in dem Rohr vorgespannten Metallschaum (242) vorgesehen werden.

6. Thermoelektrischer Generator nach Anspruch 4, wobei die Federelemente (136) zwischen Endabschnitten der Rohre vorgesehen sind und die Federelemente vorgesehen werden durch Abschnitte eines in seiner Längsrichtung elastischen Sammelrohrs, das mehrere Rohre (130), die die Endabschnitte bilden, miteinander in Fluidkommunikation verbindet, wobei das elastische Sammelrohr die Vorspannung zwischen den Endabschnitten vorsieht.

7. Thermoelektrischer Generator nach einem der vorangehenden Ansprüche, wobei die Wärmesenkenrohre oder die Wärmequellenrohre an Ihren Endabschnitten miteinander über ein flexibles Sammelrohr (136) in Fluidkommunikation verbunden sind, das im Wesentlichen keine Kraft auf die Rohre ausübt und die Federkraft der Vorspann-Lagervorrichtung die im Wesentlichen die gesamte Vorspannung zwischen den Rohren vorsieht.

8. Thermoelektroscher Generator nach einem der vorangehenden Ansprüche, ferner umfassend: eine Strömungsführung (42), die an Stirnseiten der Rohre angeordnet ist und deren Innenseite zu den Rohren hin verjüngt ist, wobei an zumindest einer der Stirnseiten innerhalb des Gehäuses eine Sammelkammer vorgesehen ist, die in Fluidkontakt mit allen Wärmequellenrohren oder mit allen Wärmesenkenrohren des Generators steht, wobei zwischen der Sammelkammer (70) und den Stirnseiten der Rohre die Strömungsführung vorgesehen ist.

9. Verfahren zur Herstellung eines thermoelektrischer Generators mit den Schritten: Einbringen mindestens eines Wärmequellenrohrs (20), mindestens eines Wärmesenkenrohrs (30) und mindestens eines Generatorelements (10) in ein Gehäuse (50), wobei in dem Gehäuse ferner eine Vorspann-Lagervorrichtung (40; 136; 242; 322, 332) angeordnet wird, die eine Federkraft zur Ausübung einer Vorspannung erzeugt, mit der die Rohre (20, 30) unmittelbar gegeneinander vorgespannt werden und die Rohre das dazwischen liegende Generatorelement (10) zusammenpressen, wobei Rohre in die Vorspann-Lagervorrichtung (40) eingespannt werden , **dadurch gekennzeichnet, dass** die Vorspann-Lagervorrichtung zwei Bodenplatten (40) umfasst, die mit dem Gehäuse fest verbunden werden, wobei die Rohre (20, 30) der Länge nach zwischen Oberflächen der Bodenplatten eingespannt werden, die den Rohren zugewandt sind und Mikro- oder Makrostrukturen aufweisen, die mit Stirnseiten der Rohre einen Kraftschluss mit einer definierten Maximal-Haftkraft oder einen durch eine definierte Maximal-Radialkraft lösbaren Formschluss bilden, und wobei die Vorspann-Lagervorrichtung durch die Bodenplatten, deren Oberflächen und die Stirnseiten der Rohre (20, 30) gebildet werden.

10. Verfahren zur Herstellung eines thermoelektrischer Generators mit den Schritten: Einbringen mindestens eines Wärmequellenrohrs (20), mindestens eines Wärmesenkenrohrs (30) und mindestens eines Generatorelements (10) in ein Gehäuse (50), wobei in dem Gehäuse ferner eine Vorspann-Lagervorrichtung (40; 136; 242; 322, 332) angeordnet wird, die eine Federkraft zur Ausübung einer Vorspannung erzeugt, mit der die Rohre (20, 30) unmittelbar gegeneinander vorgespannt werden und die Rohre das dazwischen liegende Generatorelement (10) zusammenpressen, wobei die Vorspann-Lagervorrichtung in die Rohre eingespannt wird und die Rohre mit einer Kraft durch eine Innenseite des Gehäuses (50) beaufschlagt werden, durch das die Vorspann-Lagervorrichtung abgestützt wird, **dadurch gekennzeichnet, dass** die Vorspann-Lagervorrichtung Federelemente (242; 322, 332) umfasst, die innerhalb des Wärmesenkenrohrs oder innerhalb des Wärmequellenrohrs unter Vorspannung in dem Rohr angeordnet sind, wobei die Vorspannung der Federelemente (242; 322, 332) auf gegenüberliegende Abschnitte von Innenseiten des Rohrs (220, 230; 320, 330) radial nach außerhalb der Innenseiten wirkt und das Rohr, in dem die Federelemente vorgesehen sind, elastisch ausgestaltet ist, um die Vorspannung an ein benachbartes Rohr weiterzugeben, oder wobei die Federelemente (136) zwischen Endabschnitten mehrer Wärmesenkenrohre oder Wärmequellenrohre angeordnet sind, die in Längserstreckung oder Quererstreckung der Rohre über die Wärmequellenrohre bzw. Wärmesenkenrohre hinausragen, wobei die Vorspannung der Federelemente auf gegenüberliegende Endabschnitte drückt.

## Claims

1. Thermoelectric generator comprising a housing (50), in which at least one heat source pipe (20), at least one heat sink pipe (30) and at least one generator element (10) between the heat source pipe and the heat sink pipe are arranged, a preloaded mounting device (40; 136; 242; 322, 332) being provided in the housing and providing a spring force with which at least some of the pipes (20, 30) are loaded directly and with which the pipes are preloaded relative to each other, and which presses the pipes (20, 30) and the generator element (10) located in between together, an inner side of the housing (50) providing a support for the preloaded mounting device, which is loaded with an opposing force to the spring force of the preloaded mounting device, **characterized in that** the preloaded mounting device comprises two base plates (40), which are firmly connected to the housing, wherein the pipes (20, 30) are clamped in over their length between surfaces of the base plates which face the pipes and have microstructures or macrostructures which, with the ends of the pipes, form a force fit with a defined maximum adhesive force or a form fit that can be detached by a defined maximum radial force, and wherein the preloaded mounting device is formed by the base plates, their surfaces and the ends of the pipes (20, 30).

2. Thermoelectric generator according to Claim 1, wherein the base plates (40), the pipes (20, 30) or both are formed from at least slightly elastic material, wherein the maximum adhesive force and the maximum radial force are defined by the elasticity of the elastic material and by the height of the microstructure or macrostructure, the preloaded mounting device supports the pipes with two degrees of freedom in directions which extend along the surfaces, and along which the preloaded mounting device also extends a preload, with which the pipes are loaded and which is produced by the elasticity of the base plates and/or the pipes.

3. Thermoelectric generator according to Claim 1 or 2, wherein the surfaces or the base plates (40) themselves have a wave profile or a grid as macrostructures, which has repeating elevations or depressions in at least two directions along the surface.

4. Thermoelectric generator comprising a housing (50), in which at least one heat source pipe (20), at least one heat sink pipe (30) and at least one generator element (10) between the heat source pipe and the heat sink pipe are arranged, a preloaded mounting device (40; 136; 242; 322, 332) being provided in the housing and providing a spring force with which at least some of the pipes (20, 30) are loaded directly and with which the pipes are preloaded relative to each other, and which presses the pipes (20, 30) and the generator element (10) located in between together, an inner side of the housing (50) providing a support for the preloaded mounting device, which is loaded with an opposing force to the spring force of the preloaded mounting device, **characterized in that** the preloaded mounting device comprises spring elements (242; 322, 332) which are arranged within the heat sink pipe or within the heat source pipe under preload in the pipe, wherein the preload of the spring elements (242; 322, 332) on opposite sections of inner sides of the pipe (220, 230; 320, 330) acts radially towards the outside of the inner sides, and the pipe in which the spring elements are provided is configured elastically in order to pass on the preload to an adjacent pipe, or wherein the spring elements (136) are arranged between end sections of a plurality of heat sink pipes or heat source pipes which, in the longitudinal extent or transverse extent of the pipes, project beyond the heat source pipes or heat sink pipes, wherein the preload of the spring elements presses on opposite end sections.

5. Thermoelectric generator according to Claim 4, wherein the spring elements (242; 322, 332) are arranged within the heat sink pipe or the heat source pipe, and the elastic configuration of the pipes in which the spring elements are arranged is provided by a configuration of the wall thickness and of the material of the pipes which makes the latter capable of being changed in their cross section by the spring elements, wherein the spring elements have a structure which is permeable to flow, the spring elements are provided by preloaded leaf or wire springs (322, 332) in the pipe, or the spring elements are provided by preloaded metal foam (242) in the pipe.

6. Thermoelectric generator according to Claim 4, wherein the spring elements (136) are provided between end sections of the pipes, and the spring elements are provided by sections of a manifold which is elastic in its longitudinal direction and which connects multiple pipes (130) which form the end sections to one another in fluid communication, wherein the elastic manifold provides the preload between the end sections.

7. Thermoelectric generator according to one of the preceding claims, wherein the heat sink pipes or the heat source pipes are connected to one another in fluid communication at their end sections via a flexible manifold (136), which exerts substantially no force on the pipes, and the spring force of the preloaded mounting device provides substantially the whole of the preload between the pipes.

8. Thermoelectric generator according to one of the preceding claims, also comprising: a flow guide (42), which is arranged at the ends of the pipes and the inner side of which tapers towards the pipes, wherein, on at least one of the ends within the housing, a collecting chamber is provided, which is in fluid contact with all the heat source pipes or with all the heat sink pipes of the generator, wherein the flow guide is provided between the collecting chamber (70) and the ends of the pipes.

9. Method for producing a thermoelectric generator, comprising the steps: introducing at least one heat source pipe (20), at least one heat sink pipe (30) and at least one generator element (10) into a housing (50), a preloaded mounting device (40; 136; 242; 322, 332) also being arranged in the housing and generating a spring force for the exertion of a preload, with which the pipes (20, 30) are preloaded directly relative to one another, and the pipes press the generator element (10) located in between together, pipes being clamped into the preloaded mounting device (40), **characterized in that** the preloaded mounting device comprises two base plates (40), which are firmly connected to the housing, wherein the pipes (20, 30) are clamped in over their length between surfaces of the base plates which face the pipes and have microstructures or macrostructures which, with the ends of the pipes, form a force fit with a defined maximum adhesive force or a form fit that can be detached by a defined maximum radial force, and wherein the preloaded mounting device is formed by the base plates, their surfaces and the ends of the pipes (20, 30).

10. Method for producing a thermoelectric generator, comprising the steps: introducing at least one heat source pipe (20), at least one heat sink pipe (30) and at least one generator element (10) into a housing (50), a preloaded mounting device (40; 136; 242; 322, 332) also being arranged in the housing and generating a spring force for the exertion of a preload, with which the pipes (20, 30) are preloaded directly relative to one another, and the pipes press the generator element (10) located in between together, the preloaded mounting device being clamped into the pipes and the pipes being loaded with a force by an inner side of the housing (50) by means of which the preloaded mounting device is supported, **characterized in that** the preloaded mounting device comprises spring elements (242; 322, 332) which are arranged within the heat sink pipe or within the heat source pipe under preload in the pipe, wherein the preload of the spring elements (242; 322, 332) on opposite sections of inner sides of the pipe (220, 230; 320, 330) acts radially towards the outside of the inner sides, and the pipe in which the spring elements are provided is configured elastically in order to pass on the preload to an adjacent pipe, or wherein the spring elements (136) are arranged between end sections of a plurality of heat sink pipes or heat source pipes which, in the longitudinal extent or transverse extent of the pipes, project beyond the heat source pipes or heat sink pipes, wherein the preload of the spring elements presses on opposite end sections.

## Revendications

1. Générateur thermoélectrique présentant un boîtier (50) dans lequel sont disposés au moins un tube (20) de source de chaleur, au moins un tube (30) de drain de chaleur et au moins un élément générateur (10) disposé entre le tube de source de chaleur et le tube de drain de chaleur, un ensemble (40; 136; 242; 322; 332) de palier de précontrainte étant prévu dans le boîtier et exerçant une force élastique appliquée directement sur au moins une partie des tubes (20, 30), par laquelle les tubes sont précontraints l'un vers l'autre et qui comprime ensemble les tubes (20, 30) ainsi que l'élément générateur (10) situé entre eux,
le côté intérieur du boîtier (50) présentant pour l'ensemble de palier de précontrainte un appui sur lequel une force de réaction à la force élastique de l'ensemble de palier de précontrainte est appliquée, **caractérisé en ce que**
l'ensemble de palier de précontrainte comporte deux plaques de fond (40) reliées solidairement au boîtier,
**en ce que** les tubes (20, 30) sont comprimés dans le sens de leur longueur entre des surfaces des plaques de fond tournées vers les tubes et présentent des microstructures et des macrostructures qui forment avec les côtés frontaux des tubes une correspondance mécanique dont la force d'adhérence maximale est définie ou une correspondance géométrique libérable par une force radiale maximale définie, l'ensemble de palier de précontrainte étant formé par les plaques de fond, leur surface et les côtés frontaux des tubes (20, 30) .

2. Générateur thermoélectrique selon la revendication 1, dans lequel les plaques de fond (40), les tubes (20, 30) ou les deux sont formés d'un matériau au moins légèrement élastique, la force maximale de retenue et la force radiale maximale étant définies par l'élasticité du matériau élastique et par la hauteur de la microstructure ou de la macrostructure, l'ensemble de palier de précontrainte montant les tubes avec deux degrés de liberté dans des directions qui s'étendent le long des surfaces et le long desquelles l'ensemble de palier de précontrainte exerce également une précontrainte qui s'applique sur les tubes et qui est formée par l'élasticité des plaques de fond ou des tubes.

3. Générateur thermoélectrique selon les revendications 1 ou 2, dans lequel les surfaces ou les plaques de fond (40) présentent elles-mêmes comme macrostructures un profil ondulé ou une trame qui présente des rehaussements ou des creux qui se répètent le long de la surface dans au moins deux directions.

4. Générateur thermoélectrique présentant un boîtier (50) dans lequel sont disposés au moins un tube (20) de source de chaleur, au moins un tube (30) de drain de chaleur et au moins un élément générateur (10) disposé entre le tube de source de chaleur et le tube de drain de chaleur, un ensemble (40; 136; 242; 322; 332) de palier de précontrainte étant prévu dans le boîtier et exerçant une force élastique appliquée directement sur au moins une partie des tubes (20, 30), par laquelle les tubes sont précontraints l'un vers l'autre et qui comprime ensemble les tubes (20, 30) ainsi que l'élément générateur (10) situé entre eux,
le côté intérieur du boîtier (50) présentant pour l'ensemble de palier de précontrainte un appui sur lequel une force de réaction à la force élastique de l'ensemble de palier de précontrainte est appliquée, **caractérisé en ce que**
l'ensemble de palier de précontrainte présente des éléments élastiques (242; 322, 332) disposés sous précontrainte dans le tube de drain de chaleur ou dans le tube de source de chaleur, la précontrainte des éléments élastiques (242; 322, 332) agissant sur des parties opposées des côtés intérieurs du tube (220, 230; 320, 330) radialement vers l'extérieur des côtés intérieurs et le tube dans lequel les éléments élastiques sont prévus étant élastique pour transmettre la précontrainte à un tube voisin ou les éléments élastiques (136) étant disposés entre des parties d'extrémité de plusieurs tubes de drain de chaleur ou tubes de source de chaleur qui débordent dans l'extension longitudinale ou l'extension transversale des tubes par l'intermédiaire des tubes de source de chaleur ou des tubes de drain de chaleur, la précontrainte des éléments élastiques s'exerçant sur des parties d'extrémité mutuellement opposées.

5. Générateur thermoélectrique selon la revendication 4, dans lequel les éléments élastiques (242; 322, 332) sont disposés à l'intérieur du tube de drain de chaleur ou du tube de source de chaleur et la configuration élastique des tubes dans lesquels les éléments élastiques sont disposés est fournie par une configuration de l'épaisseur de paroi et du matériau des tubes qui met ces derniers en mesure d'avoir leur section transversale modifiée par les éléments élastiques, les éléments élastiques présentant une structure perméable à l'écoulement, les éléments élastiques étant prévus sous la forme de ressorts (322, 332) à fil ou à lame précontraints dans le tube ou les éléments élastiques étant prévus sous la forme d'une mousse métallique (242) précontrainte dans le tube.

6. Générateur thermoélectrique selon la revendication 4, dans lequel les éléments élastiques (136) sont prévus entre des parties d'extrémité des tubes et les éléments élastiques sont prévus sous la forme de sections d'un tube de collecte élastique dans le sens de sa longueur, qui relie à écoulement les uns aux autres plusieurs tubes (130) qui forment les parties d'extrémité, le tube de collecte élastique assurant la précontrainte entre les parties d'extrémité.

7. Générateur thermoélectrique selon l'une des revendications précédentes, dans lequel les tubes de drain de chaleur ou les tubes de source de chaleur sont reliés les uns aux autres en communication hydraulique à leur partie d'extrémité par un tube flexible de collecte (136) qui n'exerce essentiellement aucune force sur les tubes, la force élastique de l'ensemble de palier de précontrainte assurant essentiellement la totalité de la précontrainte entre les tubes.

8. Générateur thermoélectrique selon l'une des revendications précédentes, comprenant en outre un guide d'écoulement (42) disposé sur les côtés frontaux des tubes et dont le côté intérieur se rétrécit en direction des tubes, une chambre de collecte qui est en contact hydraulique avec tous les tubes de source de chaleur ou avec tous les tubes de drain de chaleur du générateur étant prévue à l'intérieur du boîtier sur au moins l'un des côtés frontaux, le guide d'écoulement étant prévu entre la chambre de collecte (70) et les côtés frontaux des tubes.

9. Procédé de fabrication d'un générateur thermoélectrique qui présente les étapes qui consistent à :
placer au moins un tube (20) de source de chaleur, au moins un tube (30) de drain de chaleur et au moins un élément générateur (10) dans un boîtier (50), un ensemble (40; 136; 242; 322, 332) de palier de précontrainte étant en outre disposé dans le boîtier et exerçant une force élastique servant à appliquer une précontrainte par laquelle les tubes (20, 30) sont précontraints directement les uns contre les autres et les tubes compriment l'élément générateur (10) situé entre eux, les tubes étant serrés dans l'ensemble (40) de palier de précontrainte,
**caractérisé en ce que**
l'ensemble de palier de précontrainte comporte deux plaques de fond (40) reliées solidairement au boîtier,
**en ce que** les tubes (20, 30) sont comprimés dans le sens de leur longueur entre des surfaces des plaques de fond tournées vers les tubes et présentent des microstructures et des macrostructures qui forment avec les côtés frontaux des tubes une correspondance mécanique dont la force d'adhérence maximale est définie ou une correspondance géométrique libérable par une force radiale maximale définie, l'ensemble de palier de précontrainte étant formé par les plaques de fond, leur surface et les côtés frontaux des tubes (20, 30) .

10. Procédé de fabrication d'un générateur thermoélectrique qui présente les étapes qui consistent à :
introduire dans un boîtier (50) au moins un tube (20) de source de chaleur, au moins un tube (30) de drain de chaleur et au moins un élément générateur (10), un ensemble (40; 136; 242; 322; 332) de palier de précontrainte étant prévu dans le boîtier et exerçant directement sur au moins une partie des tubes (20, 30) une force élastique par laquelle les tubes sont précontraints l'un vers l'autre, les tubes (20, 30) ainsi que l'élément générateur (10) situé entre eux étant comprimés ensemble,
l'ensemble de palier de précontrainte étant serré dans les tubes et une force étant appliquée sur les tubes par le côté intérieur du boîtier (50) qui soutient l'ensemble de palier de précontrainte, **caractérisé en ce que**
l'ensemble de palier de précontrainte présente des éléments élastiques (242; 322, 332) disposés sous précontrainte dans le tube de drain de chaleur ou dans le tube de source de chaleur, la précontrainte des éléments élastiques (242; 322, 332) agissant sur des parties opposées des côtés intérieurs du tube (220, 230; 320, 330) radialement vers l'extérieur des côtés intérieurs et le tube dans lequel les éléments élastiques sont prévus étant élastique pour transmettre la précontrainte à un tube voisin ou les éléments élastiques (136) étant disposés entre des parties d'extrémité de plusieurs tubes de drain de chaleur ou tubes de source de chaleur qui débordent dans l'extension longitudinale ou l'extension transversale des tubes par l'intermédiaire des tubes de source de chaleur ou des tubes de drain de chaleur, la précontrainte des éléments élastiques s'exerçant sur des parties d'extrémité mutuellement opposées.
